# EUROPEAN PATENT APPLICATION

(11) **EP 1 329 955 A2**
(43) Date of publication of application: **23.07.2003**
(21) Application number: 03250291.6
(22) Date of filing: 17.01.2003
(51) Int. Cl.: H01L 27/00

(54) **Process for forming a multicolor display**

(30) Priority: 18.01.2002 US 349640 P
(71) Applicant: E.I. DU PONT DE NEMOURS AND COMPANY, Wilmington Delaware 19898 (US)
(72) Inventor: Meth, Jeffrey Scott, Ladenberg, Pennsylvania 19350 (US)
(74) Representative: Jones, Alan John

(57) **Abstract**

BACKGROUND OF THE INVENTION

A process for forming a multicolor display comprising selectively exposing to heat an assemblage comprising a donor element comprising a transfer layer on a base support, wherein the transfer layer comprises at least one binder and a first colorant, and a receiver element comprising a support and an image receiving layer, thereby transferring portions of the transfer layer to form a desired patterned layer on the image receiving layer of the receiver element; optionally applying a planarization layer; applying a transparent first electrical contact layer; applying a layer of organic light-emitting material; and applying a second electrical contact layer.

## Description

### BACKGROUND OF THE INVENTION

### Field of the Invention

This invention is related to the fabrication of multicolor organic light-emitting diodes (OLEDs). More particularly, it relates to a fabrication process in which an OLED is formed with an integral color filter.

### Technical Background

Light-emitting diodes fabricated with organic materials as their emissive elements have attracted attention due to their potential for use in display technology. In their most elementary form, these diodes employ a layer of emitting material bounded on one side by a hole-injecting electrode (anode) and on the other side by an electron-injecting electrode (cathode), one of which is transparent to the light produced in the emitting layer when a potential is applied across it. There may be additional layers between the emitting layer and the electrodes to facilitate charge transport and charge injection.

Organic electroluminescent materials that emit light upon application of electricity across the electrical contact layers include organic molecules such as anthracene, butadienes, coumarin derivatives, acridine, and stilbene derivatives. See, for example, U.S. Patent No. 4,356,429 to Tang. Metal complexes, such as chelated oxinoid compounds of aluminum, can be used, as described in, for example, U.S. Patent No. 5,047,687 to Van Slyke. Semiconductive conjugated polymers have also been used as electroluminescent materials. See, for example, Friend et al., U.S. Patent 5,247,190, Heeger et al., U.S. Patent No. 5,408,109, and Nakano et al., Published European Patent Application 443 861.

For multicolor displays, multiple emitting materials can be used and addressed separately. However, such systems are complex and it is difficult to obtain some desired colors. Alternatively, a diode with a single emitting material can be used with a color filter. The color filter has the desired color and pattern. Color filters are generally made by four alternative manufacturing methods: dye gelatin, pigmented photoresist, electrodeposition, and printing. The pigmented photoresist method is generally preferred. However, this requires numerous (20-30) sequential steps and wet chemical processing. Such filters can be expensive and changing patterns can be difficult.

### SUMMARY OF THE INVENTION

The present invention is directed to a process for forming a multicolor display comprising:
selectively exposing to heat an assemblage comprising a donor element comprising a transfer layer on a base support, wherein the transfer layer comprises at least one binder and a first colorant, and a receiver element comprising a support and an image receiving layer, thereby transferring portions of the transfer layer to form a desired patterned layer on the image receiving layer of the receiver element,
applying a transparent first electrical contact layer;
applying a layer of organic light-emitting material; and
applying a second electrical contact layer.
Optionally, a planarization layer may be applied to the patterned layer on the image receiving layer.

In a typical embodiment, the optional planarization layer is applied to the patterned layer on the image receiving layer, the transparent first electrical layer is applied to the planarization layer, the organic light-emitting material is applied to the first electrical contact layer and the second electrical contact layer is applied to the first electrical contact layer. In the absence of the planarization layer, the transparent first electrical layer is applied to the patterned layer on the image receiving layer.

Alternately, the patterned layer on the image receiving layer is transferred to a permanent substrate prior to application of the optional planarization layer, or in its absence to the transparent first electrical layer

### BRIEF DESCRIPTION OF THE DRAWINGS

Figure 1 is a schematic diagram of a light-emitting device of the invention.
Figure 2 is a schematic diagram of an assemblage comprising a donor element and a receiver element for use with the process of the present invention.
Figure 3 illustrates the receiver element of Fig. 2 after exposure and separation from the donor element, wherein the receiver element comprising a permanent substrate, such as glass, includes a patterned layer of colorant transferred from the transfer layer of the donor element, in accordance with the present invention.
Figure 4 illustrates the receiver element of Fig. 2 after exposure and separation from the donor element, wherein the receiver element includes a patterned layer of colorant transferred from the transfer layer of the donor element, and transfer of the patterned layer of colorant to a permanent receptor, in accordance with the present invention.

### DETAILED DESCRIPTION OF THE PREFERRED EMBODIMENTS

In accordance with the present invention, a color filter element is made by a thermal transfer process, and then overlaid with additional layers to form an organic light-emitting diode. An assemblage is provided comprising a donor element and a receiver element. The donor element comprises a transfer layer having at least one polymeric binder and a first colorant on a base support. The receiver element comprises a support and an optional adhesive layer. The assemblage is exposed to heat in a pattern corresponding to the desired color filter pattern, resulting in the transfer of a color pattern onto the receiver element. If desired, one or more additional color patterns are transferred, by thermal transfer, to the receiver element, having an image of the first color thereon, using additional donor elements having transfer layers with different colorants. If the receiver element is used as the permanent substrate for the color filter, typically, the support in the receiver element is a dimensionally stable transparent material, such as glass. If the receiver element is used as an intermediate transfer element, the receiver element support is a flexible material such as polyethlene terephthalate, and the pattern formed on the receiver element may be then transferred to a permanent substrate, such as glass, in a second step of the process without the use of excessive heat, such as by lamination. The resultant color filter element is then overlaid with a planarization layer, a first electrical contact layer, a light-emitting layer, and a second electrical contact layer to form a light-emitting device. The additional layers may variously be applied by thermal transfer, vaporization, extrusion, or solution coating techniques.

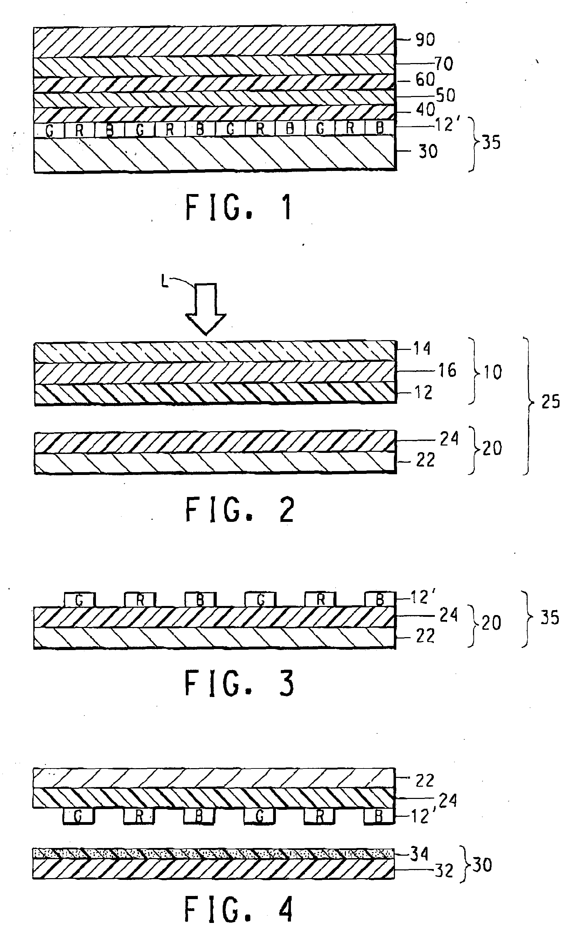

A preferred embodiment of the light-emitting device formed by the process of the invention is shown in Figure 1. The device comprises color filter element (35), made up of substrate (22) wherein the receiver support is glass, or a permanent substrate (30) wherein the image from the receiver element is transferred in a separate step to a permanent substrate such as glass, a color filter pattern (12'), and planarization layer (40); anode (50); optional hole injection layer (60); electroluminescent layer (70); an optional electron transport layer (80); and cathode (90).

The first step in the process of the invention is to selectively expose to heat an assemblage comprising a donor element and a receiver element.

Figure 2 exemplifies an assemblage (25) comprising a donor element (10) and a receiver element (20) for use in the process of the present invention.

### Donor Element

The donor element (10) comprises a thermally imageable transfer layer (12) comprising at least one polymeric binder and a first colorant, a base support (14) and an optional heating layer (16) between the base support (14) and the transfer layer (12). As best seen in Figure 2, the base support (14) provides support for the heating layer (16), if present, and the transfer layer (12).

### 1. Base Support

The base support (14) of the donor element (10) is a dimensionally stable sheet material. Typically, the donor element (10) is flexible to facilitate subsequent processing steps, as described further, below. The base support (14) is transparent to laser radiation to allow for exposure of the transfer layer (12), as described further, below.

Examples of transparent, flexible films appropriate for use as the base support (14) include, for example, polyethylene terephthalate ("polyester"), polyether sulfone, polyimides, poly(vinyl alcohol-co-acetal), polyethylenes, or cellulose esters, such as cellulose acetate, and polyvinyl chloride. Typically, the base support (14) of the donor element (10) is polyethylene terephthalate that has been plasma treated to accept the optional heating layer (16). Other materials can be present as additives in the base support, as long as they do not interfere with the essential function of the support. Examples of such additives include plasticizers, coating aids, flow additives, slip agents, antihalation agents, antistatic agents, surfactants, and others which are known for use in the formulation of films. The base support generally has a thickness in the range of 1-8 mils (25-200 microns), preferably 3-5 mils (75-125 microns).

### 2. Heating Layer

As best seen in Figure 2, the function of the optional heating layer (16) of the donor element (10) is to absorb the laser radiation (L) used to expose the transfer layer (12) and to convert the radiation into heat. The heating layer is typically a metal.

Some examples of other suitable materials are transition metal elements and metallic elements of Groups 13, 14, 15 and 16, their alloys with each other, and their alloys with the elements of Groups 1 and 2, which have less adhesion to the colorant material (12), or may be treated to have less adhesion, than the adhesion of the colorant material (12) to the receiving surface of the substrate (24) and absorb the wavelength of the laser. The IUPAC numbering system is used throughout, where the groups are numbered from left to right as 1-18 (CRC Handbook of Chemistry and Physics, 81^{st} Edition, 2000). Tungsten (W) is an example of a suitable transition metal,

Carbon, a Group 14, nonmetallic element, may also be used.

Nickel, aluminum, chromium and nickel vanadium are typical metals for the heating layer (16). Electron beam deposited nickel is most typical because it has been found that the release of the colorant in the transfer layer may be best facilitated from nickel by oxygen plasma treatment, as discussed further, below.

Alternatively, in Figure 2, the optional heating layer (16) can be an organic layer comprising an organic binder and an infrared absorber. Examples of suitable binders are those that decompose at fairly low temperatures when heated such as polyvinyl chloride, chlorinated polyvinyl chloride and nitrocellulose. Examples of near infrared absorbers are carbon black and infrared dyes.

The thickness of the heating layer (16) depends on the optical absorption of the metals used. For chromium, nickel vanadium or nickel, a layer of 80-100 Angstroms is preferred. An aluminum heating layer about 40-50 Angstroms thick, shows high optical absorption. If carbon is used, the heating layer would be from about 500 to about 1,000 Angstroms.

Although it is preferred to have a single optional heating layer, it is also possible to have more than one heating layer, and the different layers can have the same or different compositions.

The optional heating layer (16) may be applied to the base support (14) by a physical vapor deposition technique. The term "physical vapor deposition" refers to various deposition approaches carried out in vacuum. Thus, for example, physical vapor deposition includes all forms of sputtering, including ion beam sputtering, as well as all forms of vapor deposition, such as electron beam evaporation and chemical vapor deposition. A specific form of physical vapor deposition useful in the present invention is rf magnetron sputtering. Nickel may be electron beam deposited onto the base support (14). Aluminum may be applied by resistive heating. Chromium, nickel and nickel vanadium layers may be applied by either sputtering or electron beam deposition.

### 3. Transfer Layer

The at least one polymeric binder for the transfer layer is a polymeric material having a decomposition temperature that is less than or equal to 350°C and preferably less than 300°C. The binder should be film forming and coatable from solution or from a dispersion. Binders having melting points less than about 250°C or plasticized to such an extent that the glass transition temperature is < 70°C are preferred. However, heat-fusible binders, such as waxes should be avoided as the sole binder since such binders may not be as durable, although they are useful as cobinders in decreasing the melting point of the top layer.

It is preferred that the polymeric binder does not self-oxidize, decompose or degrade at the temperature achieved during the laser exposure so that the imageable component and binder are transferred intact for improved durability. Examples of suitable binders include copolymers of styrene and (meth)acrylate esters, such as styrene/methyl-methacrylate; copolymers of styrene and olefin monomers, such as styrene/ethylene/butylene; copolymers of styrene and acrylonitrile; fluoropolymers; copolymers of (meth)acrylate esters with ethylene and carbon monoxide; polycarbonates having higher decomposition temperatures; (meth)acrylate homopolymers and copolymers; polysulfones; polyurethanes; polyesters. The monomers for the above polymers can be substituted or unsubstituted. Mixtures of polymers can also be used.

Typical polymers for the transfer layer are (meth)acrylic polymers, including, but not limited to, acrylate homopolymers and copolymers, methacrylate homopolymers and copolymers, (meth)acrylate block copolymers, and (meth)acrylate copolymers containing other comonomer types, such as styrene.

Particularly typical are polymeric binders, which are crosslinkable. Crosslinkable polymers are well-known in the art and have been discussed in, for example, in US Patent No. 6,051,318. Crosslinkable polymeric binders generally have pendant groups that are capable of undergoing free-radical induced or cationic crosslinking reactions. Pendant groups which are capable of undergoing free-radical induced crosslinking reactions are generally those which contain sites of ethylenic unsaturation, such as mono- and polyunsaturated alkyl groups; acrylic and methacrylic acids and esters. In some cases, the pendant crosslinking group can itself be photosensitive, as is the case with pendant cinnamoyl or N-alkyl stilbazolium groups. Pendant groups which are capable of undergoing cationic crosslinking reactions include substituted and unsubstituted epoxide and aziridine groups, The binders are generally homopolymers or copolymers of monomers having such crosslinkable groups. Examples of such monomers include allyl (meth)acrylate, glycidyl (meth)acrylate, hydroxyethyl(meth)acrylate, (meth)acrylic acid, and the like, where the term "(meth)acrylate" indicates acrylate, methacrylate or a combination thereof.

The transfer layer can optionally include a second polymeric binder. The second binder is a high decomposition temperature binder having a decomposition temperature greater than about 395°C. The presence of the high decomposition temperature binder increases the stability of the color filter layer in further processing steps. Examples of suitable binders having a decomposition temperature greater than about 395°C include C2 to C6 polyalkylene oxides and glycols. Typical are polyethylene oxide (PEO) (having a decomposition temperature of about 402°C) and polyethylene glycol (PEG) (having a decomposition temperature of about 399°C). Binders having a decomposition temperature greater than about 395°C can be present in the transfer layer in amounts from 0 to 15 % by weight, preferably 3 to 15 % by weight, and most preferably at least 6% by weight, based on the total weight of the transfer layer.

In another embodiment, the polymeric binder component of the transfer layer (12) comprises at least a first and a second polymeric binder, wherein the first binder has a higher Tg than the Tg of the second binder.

The first polymeric binder for the transfer layer is a polymeric material having a decomposition temperature that is less than or equal to 350°C and preferably less than 300°C. The first binder has a Tg at least 10°C higher than the Tg of the second binder. Preferably the Tg of the first binder is at least 70°C. The binder should be film forming and coatable from solution or from a dispersion. It is preferred that the first polymeric binder does not self-oxidize, decompose or degrade at the temperature achieved during the laser exposure so that the colorant component and first binder are transferred intact for improved durability.

The second polymeric binder is one having a Tg at least 10°C less than the Tg of the first polymeric binder. It is preferred that the Tg be less than 70°C.

It is typical that both the first polymeric binder and the second polymeric binder be crosslinkable. The crosslinkable binders discussed above can be used, provided that they have the appropriate relative Tg's and decomposition temperatures. Preferred first and second polymeric binders for the transfer layer are copolymers of glycidyl (meth)acrylate. It is known in the art that the Tg of such copolymers can be adjusted by choosing appropriate comonomers. In general, the Tg of the copolymer can be lowered by using monomers that form homopolymers having a low Tg. Examples of such monomers include butyl (meth)acrylate and butadiene. Conversely, the Tg of the copolymer can be increased by using monomers that form homopolymers having a high Tg. Examples of such monomers include methyl (meth)acrylate and styrene. The ratio of first polymeric binder to second polymeric binder is generally in the range of 1:10 to 10:1.

The total polymeric binder concentration is generally in the range of about 15-50% by weight, based on the total weight of the transfer layer, preferably 30-40% by weight.

The colorant in the transfer layer can be a pigment dispersion or a non-sublimable dye. It is preferred to use a pigment dispersion as the colorant for stability and for color density, and also for the high decomposition temperature. The pigment in the dispersion is preferably chosen from pigments having (1) high transparency, wherein at least about 80% of light is transmitted through the pigment, and (2) small particle size, wherein the average particle size is about 100 nanometers. Some examples of transparent pigments that can be used in this invention include RS Magenta 234-007™, GS Cyan 249-0592 ™, and RS Cyan 248-061, from Sun Chemical Co. (Fort Lee, NJ); BS Magenta RT-333D ™, Microlith Yellow 3G-WA™, Microlith Yellow 2R-WA™, Microlith Blue YG-WA ™, Microlith Black C-WA ™, Microlith Violet RL-WA ™, Microlith Red RBS-WA ™, Cromophthal Red 3B, Irgalite Blue GLO, and Irgalite Green 6G, from Ciba-Geigy (Newport, DE); Fanchon Fast Yellow 5700, from Bayer (Pittsburgh, PA); any of the Heucotech Aquis II ™ series; any of the Heucosperse Aquis III ™ series; and the like.

The amount of colorant present in the transfer layer is chosen such that optical densities of the donor element are preferably between about 1.0 and about 2.0 for red, blue and green, and between about 3.0 and about 4.0 for black. In general, the colorant is present in an amount of from about 20 to about 80% by weight, typically about 30 to about 50% by weight, based on the total weight of the transfer coating.

A dispersant is usually present when a pigment is to be transferred, in order to achieve maximum color strength, transparency and gloss. The dispersant is generally an organic polymeric compound and is used to separate the fine pigment particles and avoid flocculation and agglomeration. A wide range of dispersants is commercially available. A dispersant will be selected according to the characteristics of the pigment surface and other components in the composition as practiced by those skilled in the art. However, one class of dispersant suitable for practicing the invention is that of the AB dispersants. The A segment of the dispersant adsorbs onto the surface of the pigment. The B segment extends into the solvent into which the pigment is dispersed. The B segment provides a barrier between pigment particles to counteract the attractive forces of the particles, and thus to prevent agglomeration. The B segment should have good compatibility with the solvent used. The AB dispersants of choice are generally described in "Use of AB Block Polymers as Dispersants for Non-aqueous Coating Systems", by H. C. Jakubauskas, *Journal of Coating Technology,* Vol. 58, No. 736, pages 71-82. Suitable AB dispersants are also disclosed in U.K. Patent 1,339,930 and U.S. Patent Nos. 3,684,771; 3,788,996; 4,070,388; 4,912,019; and 4,032,698. Conventional pigment dispersing techniques, such as ball milling, sand milling, etc., can be employed. For color filter applications, the binder polymer of the transfer layer can also act as a dispersant for the pigment.

Other materials can be present as additives in the transfer layer as long as they do not interfere with the essential function of the layer. Some examples of such additives include coating aids, plasticizers, flow additives, slip agents, antihalation agents, antistatic agents, surfactants, and others that are known to be used in the formulation of coatings. However, it is preferred to minimize the amount of additional materials in this layer, as they may deleteriously affect the final product after transfer to the final support.

The transfer layer generally has a thickness in the range of about 0.1 to 5 micrometers, preferably in the range of about 0.1 to 1.5 micrometers. Thicknesses greater than about 5 micrometers are generally not preferred as they require excessive energy in order to be effectively transferred to the receiver

Although it is typical to have a single transfer layer, it is also possible to have more than one transfer layer, and the different layers can have the same or different compositions, as long as they all function as described above. The total thickness of the combined transfer layers should be in the range given above.

The transfer layer(s) can be coated onto the heating layer of the donor, if present, or directly on a support as a dispersion in a suitable solvent, however, it is preferred to coat the layer(s) from a solution. Any suitable solvent can be used as a coating solvent, as long as it does not deleteriously affect the properties of the assemblage, using conventional coating techniques or printing techniques, for example, gravure printing.

An ejection layer (not shown) may optionally be provided between the optional heating layer (16) and the transfer layer (12), as is known in the art. The ejection layer decomposes into gaseous molecules when heated, providing additional force to cause transfer of exposed portions of the transfer layer (12) to the receiver element (20). A polymer having a relatively low decomposition temperature (less than about 350°C, preferably less than about 325°C, and more preferably less than about 280°C) may be used. In the case of polymers having more than one decomposition temperature, the first decomposition temperature should be lower than 350°C. Suitable ejection layers are disclosed in U.S. Patent No. 5,766,819, assigned to the assignee of the present invention. Thermal additives may also be provided in the ejection layer to amplify the effect of the heat generated in the heating layer (16), as is known in the art and also described in U.S. Patent No. 5,766,819. U.S. Patent No. 5,766,819 is incorporated by reference herein. By providing an additional decomposition pathway for the creation of gaseous products, additional propulsive forces can be generated to assist in the transfer process.

Optionally, there may be a release means (not shown) provided between the heating layer (16), if present, or the support (14) and the transfer layer (12). This may be accomplished by oxygen plasma treating the heating layer (16) or the support (14). Alternately, release layers may be applied to either the heating layer (16), if present, or the support (14) prior to application of the transfer layer (12). Some useful layers include hexamethyldisilazane (HMDS) available from Arch Chemicals, Inc., Norwalk CT., dichlorosilane perfluordecane, available from Gelest, Inc., Tullytown, PA., tridecafluoro-1.1.2.2-tetrahydooctyl-1-methyldichlorosilane, available from United Chemical Technologies, Inc., Bristol, PA., etc. Release means may also be a heat activated release material.

### Receiver Element

The receiver element, illustrated in Figure 2, comprises a receiver support (22) and an image-receiving layer (24), and optionally a cushion or release layer (26).

The receiver support (22) can be made of the same materials as the base support of the donor element. In addition, opaque materials, such as polyethylene terephthalate filled with a white pigment such as titanium dioxide, ivory paper, or synthetic paper, such as Tyvek® spunbonded polyolefin may be used as the receiver support. Typical materials for the receiver support (22) are polyethylene terephthalate and polyimide. Alternately, when the receiver element is used as the permanent substrate, the receiver support may include transparent plastic films, as described above, glass, and composites thereof. Thin glass substrates are typically used.

The image-receiving layer (24) may be a coating of, for example, a polycarbonate; a polyurethane; a polyester; polyvinyl chloride; styrene/acrylonitrile copolymer; poly(caprolactone); vinylacetate copolymers with ethylene and/or vinyl chloride; (meth)acrylate homopolymers (such as butyl-methacrylate) and copolymers; and mixtures thereof. This image-receiving layer may be present in any amount effective for the intended purpose. In general, good results have been obtained at coating weights of 1 to 5 g/m².

In addition to the image-receiving layer, the receiver element may optionally include one or more other layers between the receiver support and the image receiving layer. One additional layer between the image-receiving layer and the support is a release layer. In the intermediate transfer process where the receiver element is the intermediate transfer element, the release layer can provide the desired adhesion balance to the receiver element so that the image-receiving layer adheres to the receiver element during exposure and separation from the donor element, but promotes the separation of the image receiving layer from the receiver support upon transfer, for example by lamination, of the image layer to a permanent support. The color image layer is thus between the permanent support (e.g., glass or polarizing element) and the image receiving layer, and the image receiving layer can act as a planarizing layer for the LCD device. Examples of materials suitable for use as the release layer include polyamides, silicones, vinyl chloride polymers and copolymers, vinyl acetate polymers and copolymers and plasticized polyvinyl alcohols. The release layer can have a thickness in the range of 1 to 50 microns. A cushion layer which is a deformable layer may also be present in the receiver element, typically between the release layer and the receiver support. The cushion layer may be present to increase the contact between the receiver element and the donor element when assembled. Examples of suitable materials for use as the cushion layer include copolymers of styrene and olefin monomers such as styrene/ethylene/butylene/-styrene, styrene/butylene/styrene block copolymers, and other elastomers. An adhesive layer may be present between the cushion layer and the release layer or between the cushion layer and the image receiving layer. Examples of suitable adhesives include hot melt adhesives such as ethylene vinyl acetate. Receiving elements suitable for use in color filter array applications are disclosed as transfer elements in U.S. Patent No. 5,565,301 which is hereby incorporated by reference. Typical polymers for the receiver layer are (meth)acrylic polymers, including, but not limited to, acrylate homopolymers and copolymers, methacrylate homopolymers and copolymers, (meth)acrylate block copolymers, and (meth)acrylate copolymers containing other comonomer types, such as styrene. Alternate receiver elements are disclosed in US Patent No. 5,534,387. One preferred example is the WaterProof® Transfer sheet sold by DuPont. Typically, it has an ethylene/vinyl acetate copolymer in the surface layer comprising more ethylene than vinyl acetate.

As seen in Figure 2, the outer surface of the transfer layer (12) of the donor element (10) is brought into close proximity with the image receiving layer (24) of the receiving element (20) to form the assemblage (25). Vacuum and/or pressure can be used to hold the donor element (10) and the receiver element (20) together to form the assemblage (25). As another alternative, the donor element (10) and receiver element (20) can be taped together and taped to the imaging apparatus. A pin/clamping system can also be used. Alternatively, the surface of the donor element and or the receiver element may be roughened during coating by laminating a matte polyethylene coversheet. This will improve the contact between the donor element (10) and the receiver element (20), and facilitate the removal of air from between the donor element (10) and the receiver element (20).

The assemblage (25) is then exposed through the donor element (10) in selected areas by radiation (L) in the form of heat or light. As mentioned above, the exposure pattern is the desired pattern of the color filter. The optional heating layer (16) or the transfer layer absorb the radiation (L), generating heat which causes transfer of the heat-exposed portions of the transfer layer (12) to the receiver element (20).

After exposure, the donor element (10) is separated from the receiver element (20). This may be done by simply peeling the two elements apart. Very little peel force is typically required; the donor support (10) may simply be separated from the receiver element (20). Any conventional manual or automatic separation technique may be used.

After separation of the donor element (10) and the receiver element (20), the desired pattern of colorant material has been exposed and transferred to the receiver element, while the unexposed, unwanted portions of the transfer layer (12) remain on the donor element,

The radiation (L) is typically provided by a laser. Laser radiation may be provided at a laser fluence of up to about 1 J/cm², preferably about 75-500 mJ/cm² Other techniques that generate sufficient heat to cause transfer of the colorant material layer may be used, as well. For example, a thermal print head, or microscopic arrays of metallic tips with diameters ranging from about 50 nanometers, such as those used in atomic force microscopy, to about 5 microns, may also be used. A current is provided to the metallic tips to generate the heat. Higher resolutions may be obtained with small metallic tips than with a laser.

Various types of lasers may be used to expose the thermally imageable transfer layer (12) of colorant material. The laser preferably emits in the infrared, near-infrared or visible region. Particularly advantageous are diode lasers emitting in the region of 750 to 870 nm which offer a substantial advantage in terms of their small size, low cost, stability, reliability, ruggedness and ease of modulation. Diode lasers emitting in the range of 780 to 850 nm are most preferred. Such lasers are available from, for example, Spectra Diode Laboratories, San Jose, CA. Other types of lasers may also be used, as is known in the art, providing that the absorption of the heating layer (16) matches the emitting wavelength of the laser.

If the donor element (10) and the receiver element (20) are both flexible, the assembly (25) can be conveniently mounted on a drum to facilitate laser imaging.

The transfer step can be repeated with the same receiver element bearing the first pattern (12') and one or more different donor elements having a colorant of a different color, to prepare a multicolor color filter pattern. If the receiver support is the permanent substrate, this forms a color filter (35) as shown in Figure 3. Optionally, an additional adhesive layer (not shown) may be present on the permanent substrate, e.g., glass, before transfer.

As best seen in Figure 4, if the receiver element is an intermediate transfer element, the next step in the process of the invention is to transfer the patterned layer from the receiver element to a permanent substrate, such as glass. After formation of the patterned layer (12') of colorant material, which may be a single color or multicolor pattern, on the receiver element (20), the receiver element (20), including the patterned layer (12'), is brought into contact with a permanent substrate (30), as shown in Fig. 4. The substrate (30) may include a base element (32) and an adhesive coating (34) to increase the adhesion of the patterned layer (12') to the substrate. The adhesive coating (34) may be a suitable polycarbonate, a polyurethane, a polyester, polyvinyl chloride, styrene/acrylonitrile copolymer, poly(capro-lactone), vinylacetate copolymers with ethylene and/or vinyl chloride, (meth)acrylate homopolymers (such as butyl-methacrylate), copolymers, and mixtures thereof.

It is important that the receiving surface of the substrate (30) have greater adhesion to the patterned layer (12') than the adhesion of the patterned layer and image receiving layer to the receiver support. The substrate (30) may be any material which will support the subsequent layers and transmit light generated by the light-emitting material. Suitable materials include transparent plastic films, as described above, glass, and composites. Thin glass substrates are preferred. Glass as thin as 50 microns can be used. The upper limit on thickness is set by the weight and desired properties of the end product. The thickness is usually less than 5 millimeters.

Preferably, the desired pattern (12') is transferred to the substrate (30) by lamination. Nip or press lamination may be used, as is known in the art. A roll-to-roll HRL-24 Laminator, manufactured by DuPont, Wilmington, DE, is preferably used to accomplish the lamination. The minimum useful pressure is about 30 psi. The maximum pressure is determined by the pressure at which unwanted contamination, such as a speck of dust, can cause the substrate to crack. Generally the pressure should be less than about 10,000 psi (about 1,000 kg per square cm). After separation of the donor element (10) from the substrate (30), the desired pattern (12') of colorant material is transferred to the substrate to form a color filter element (35).

The next step in the process of the invention is to apply an optional planarization layer (40) or a first electrical contact layer (50) to the patterned layer (12') present on the image receiving layer of the receiver element (20) or on the substrate (30).

The optional planarization layer (40) protects the underlying color filter element and smooths and/or levels the surface. Materials useful as planarization layers are well known, and generally include polymeric materials which may be crosslinkable or thermally curable. Examples of suitable materials include homopolymer and copolymers of (meth)acrylate esters, such as polyacrylate and polymethylmethacrylate, and their substituted analogs; copolymers of styrene and (meth)acrylate esters, such as styrene/methyl-methacrylate; copolymers of styrene and olefin monomers, such as styrene/ethylene/butylene; copolymers of styrene and acrylonitrile; fluoropolymers; copolymers of (meth)acrylate esters with ethylene and carbon monoxide; polycarbonates; polysulfones; polyurethanes; polyesters; and polyimides. The monomers for the above polymers can be substituted or unsubstituted. Mixtures of polymers can also be used. Thermoset materials such as epoxy and amino resins can also be used. Preferred materials for the planarization layer are copolymers of methyl methacrylate, butyl methacrylate, methacrylic acid, and glycidyl methacrylate. Low molecular weight polymers are typical for the planarization layer because of their increased flow under stress. Alternately, the image receiving layer (24) that is transferred with the pattern layer (12') of colorant material may function as the planarizing layer.

The optional planarization layer (40) is applied using any conventional coating technique. Such techniques are well known in the art and include spin coating, casting, gravure printing, and extrusion coating processes. The planarization layer can also be applied as a preformed film and laminated to the color filter element (35). The next step in the process of the invention is to apply a first electrical contact layer (50), which is transparent. As used herein, the term "transparent" is defined to mean capable of transmitting at least about 25%, and preferably at least about 50%, of the amount of light of a particular wavelength of interest.

In most devices, the first electrical contact layer will typically be the anode. This is generally a conductive layer made of a high work function material, most typically an inorganic material with a work function above 4.5 eV. Typical inorganic materials which serve as anodes include metals such as aluminum, silver, platinum, gold, palladium, tungsten, indium, copper, iron, nickel, zinc, lead and the like, as well as alloys thereof; metal oxides and mixed metal oxides of Groups 2, 3 and 4, such as lead oxide, tin oxide, indium/tin-oxide and the like; graphite; doped inorganic semiconductors such as silicon, germanium, gallium arsenide, and the like. As is known to those working in the field of thin films, one can achieve considerable degrees of transparency with metals if the layers are thin enough. The metals generally have a thickness in the range of 20 to 300 Å; the metal/metal-oxide mixtures can be transparent at thicknesses up to as high as 2500 Å.

The anode materials are generally applied by the vapor deposition techniques discussed above.

The first electrical contact layer may be patterned, as desired. For example, the first electrical contact layer may be a series of parallel strips forming electrode lines for addressing individual pixels of the display.

The first electrical contact layer can be applied to the planarization layer (40) over the color filter element (35) in the desired pattern by positioning a patterned mask or photoresist on the planarization layer prior to applying the material of the first electrical contact layer. Alternatively, the first electrical contact layer can be applied as an overall layer and subsequently patterned using, for example, a photoresist and wet chemical etching.

The first electrical contact layer typically may have a thickness range of from about 500 Angstroms to about 5,000 Angstroms.

The next step in the process of the invention is to apply a layer of organic light-emitting material (70). The light-emitting material may be any organic electroluminescent or other organic light-emitting materials. Anthracene, naphthalene, phenanthrene, pyrene, chysene, perylene, butadienes such as 1, 4- diphenylbutadiene and tetraphenylbutadiene, coumarin derivatives, acridine and stilbenes such as transtilbene, may be used, for example, as described in U.S. Patent No. 4,356,429 to Tang and U.S. Patent No. 4,539,507 to Van Slyke et al., which are incorporated herein by reference, Metal chelated oxinoid compounds, such as AIQ3, can be used, as described in, for example, U.S. Patent No. 5,047,687 to Van Slyke. Additional metal complexes are also known to be electroluminescent.

Alternatively, semiconductive conjugated polymer materials may be used, such as those described in U.S. Patent No. 5,247,190 to Friend et al., U.S. Patent No. 5,408,109 to Heegeret al. and U.S. Patent No. 5,317,169 to Nakano et al., which are incorporated by reference herein. Examples of such polymers include poly(p-phenylenevinylene) referred to as PPV and poly (2,7-(9,9-dialkylfluorene)). PPV is preferred because its lifetime exceeds that of polyfluorenes. Mixtures of electroactive materials, such as mixtures of light emitting polymers, may also be used.

The small molecule light-emitting materials can be applied to the preceding layer from solutions using the coating techniques discussed above, or they can be deposited by vapor deposition techniques. The polymeric light-emitting materials are generally applied by coating techniques, If a hole transport layer (50) is present, the light-emitting layer is applied to the hole transport layer instead of the first electrical contact layer.

The next step in the process of the invention is to apply a second electrical contact layer (90) to the light-emitting material (70). In general, the second electrical contact layer is a cathode. The cathode can be any metal or nonmetal having a lower work function than the first electrical contact layer (50) of the device (100). Materials for the second electrical contact layer can be selected from alkali metals of Group 1 (e.g., Li, Cs), the Group 2 (alkaline earth) metals, the lanthanides and the actinides. Materials such as aluminum, indium, calcium, barium, magnesium and ytterbium, as well as combinations thereof, can be used. Ytterbium and aluminum are preferred.

The second electrical contact layer (90) may be applied to the pattern of light-emitting organic material (70) by a physical vapor deposition process and patterned by conventional techniques, as described above with respect to the first electrical contact layer (50). The second electrical contact layer may be patterned as a series of parallel strips perpendicular to the parallel strips of the first electrical contact. If an electron transport layer (80) is present, the second electrical contact layer is deposited on the electron transport layer instead of the light-emitting layer.

The second electrical contact layer (90) typically has a thickness in the range of 500-5,000 Angstroms. If the cathode is barium or calcium, the thickness is about 50 Angstroms, Such electrical contact layers are typically capped by aluminum, such that the overall thickness of the cathode is in the range of 500-5000 Angstroms. If the cathode is ytterbium or aluminum, no capping layer is needed and the thickness of the single layer itself is in the 500-5000 Angstrom range.

When it is desired to have a charge transport layer (60), this layer is applied after the first electrical contact layer (50). When the first electrical contact layer is an anode, the charge transport layer (60) is a hole transport layer. The material in this layer facilitates hole transport and/or gap matching of the light-emitting material with the anode.

Examples of hole transport materials for layer (60) have been summarized, for example, in Kirk-Othmer Encyclopedia of Chemical Technology, Fourth Edition, Vol.18, p.837-860, 1996, by Y, Wang, incorporated by reference, herein. Both hole transporting molecules and polymers can be used.

Commonly used hole transporting molecules are: N,N'-diphenyl-N,N'-bis(3-methylphenyl)-[1,1'-biphenyl]-4,4'-diamine (TPD), 1,1-bis[(di-4-tolylamino) phenyl]cyclohexane (TAPC), N,N'-bis(4-methylphenyl)-N,N'-bis(4-ethylphenyl)-[1,1'-(3,3'-dimethyl)biphenyl]-4,4'-diamine (ETPD), Tetrakis-(3-methylphenyl)-N,N,N',N'-2,5-phenylenediamine (PDA), a-Phenyl-4-N,N-diphenylaminostyrene (TPS), p-(Diethylamino)benzaldehyde diphenylhydrazone (DEH), Triphenylamine (TPA), Bis[4-(N,N-diethylamino)-2-methylphenyl](4-methylphenyl)methane (MPMP), 1-Phenyl-3-[p-(diethylamino)styryl]-5-[p-(diethylamino)phenyl] pyrazoline (PPR or DEASP), 1,2-Trans-bis(9H-carbazol-9-yl)cyclobutane (DCZB), N,N,N',N'-tetrakis(4-methylphenyl)-(1,1'-biphenyl)-4,4'-diamine (TTB), and porphyrinic compounds, such as copper phthalocyanine.

Commonly used hole transporting polymers are polyvinylcarbazole, (phenylmethyl)polysilane, polyaniline, poly(3,4-ethylenedioxythiophene) ("PEDOT"), and doped forms thereof. It is also possible to obtain hole transporting polymers by doping hole transporting molecules, such as those mentioned above into polymers such as polystyrene and polycarbonate.

The small molecule hole transport materials for layer (60) can be applied to the anode layer (50) from solutions using the coating techniques discussed above, or they can be deposited by vapor deposition techniques. The polymeric hole transport materials are generally applied by coating techniques. Typical thicknesses for the hole transport layer (60) range from about 100 to 5000 Angstroms.

Another optional layer is the electron transport layer (80), located between the organic light-emitting material and the cathode. Electron transport materials facilitate electron transport and/or gap matching of the light-emitting material and the cathode.

Examples of electron transport materials for the electron transport layer (80) include metal chelated oxinoid compounds, such as tris(8-quinolinolato-N₁O₈)aluminum (Alq₃); phenanthroline-based compounds, such as 2,9-dimethyl-4,7-diphenyl-1,10-phenanthroline (DDPA) or 4,7-diphenyl-1,10-phenanthroline (DPA), and azole compounds such as 2-(4-biphenylyl)-5-(4-t-butylphenyl)-1,3,4-oxadiazole (PBD) and 3-(4-biphenylyl)-4-phenyl-5-(4-t-butylphenyl)-1,2,4-triazole (TAZ). The charge injection layer (80) can function both to facilitate electron transport, and can also serve as a buffer layer or confinement layer to prevent quenching of the exciton at layer interfaces. Preferably, this layer promotes electron mobility and reduces exciton quenching.

The electron transport layer (80) can be applied using the same techniques described above for the hole transport layer (60). Typical thicknesses for the electron transport layer (80) range from about 100 to 5000 Angstroms.

### EXAMPLES

The following examples illustrate certain features and advantages of the present invention. They are intended to be illustrative of the invention, but not limiting. All percentages are by weight, unless otherwise indicated.

### EXAMPLE 1

The red, blue, and green donor elements were made by slot die coating the appropriate formulation onto the donor substrate to form the transfer layer. Each of the formulations included a color pigment and a dispersant, ([69]nBA/MA/AA(45.5/45.5/9)//g-MMA/MAA(28.75/71.25)[31]), where //g means that the main chain of the polymer was grafted with the indicated side chain, 69 wt% being in the main chain, and 31% in the side chain The substrate was 4 mil (100 micron) Melinex® 573 polyester film (E. I. du Pont de Nemours and Company, Wilmington, DE) which had been sputtered with a Cr heating layer to 50% transmission (Vacuum Deposit Inc, Louisville, KY). The four donor formulations are given in Table 1. These coating weights produced films that were approximately 1 micron thick, approximately 14 mg/dm².

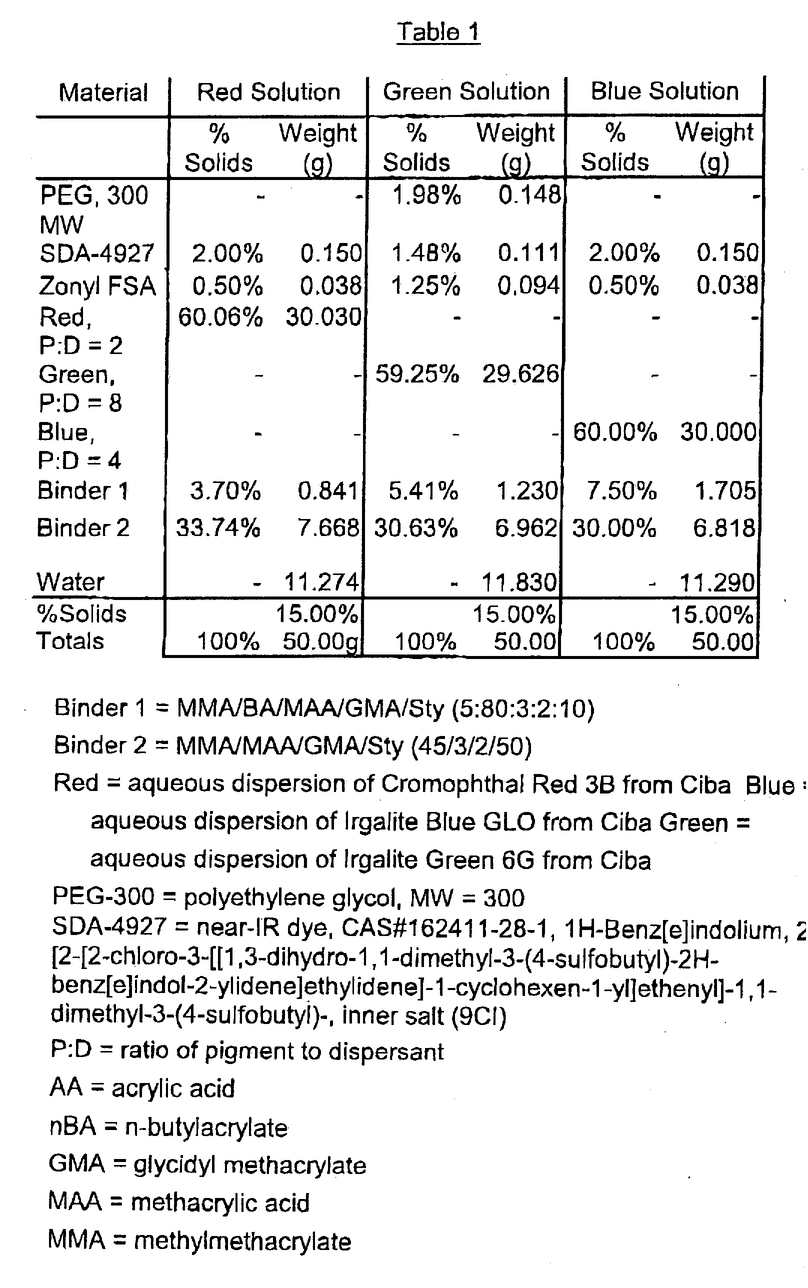

A receiver element was prepared using a support of Cronar® polyester and coated with a cushion/release layer of ethylene-vinyl acetate copolymer and an image-receiving layer comprising a latex blend of Binder1:Binder2 70:30 weight ratio. The image-receiving layer was approximately 1 micron thick, coating weight approximately 13 mg/dm².

The three donor colors and the receiver were loaded into the autoloader of the CREO 3244 Spectrum Trendsetter exposure unit available from Creo-Scitex, Inc. (Vancouver, Canada).

The assembly was exposed through the polyester base support of the donor element in a pattern comprising a series of parallel, ¼ inch lines, corresponding to the desired pattern. The red donor was imaged first, then blue, then green. Loading and unloading of all films was handled automatically. The red was exposed at 400 mJ/cm², the blue at 450 mJ/cm², and the green at 350 mJ/cm². The final image was a repeating pattern of colored red, green, and blue lines, each ¼ inch wide.

A glass substrate for the color filter element was prepared from a 2" square of glass (Corning 1737°F). The glass was cleaned by washing with soap and water, then rinsing with deionized water, then rinsing with isopropanol, then rinsing with deionized water, then drying with Nitrogen gas. An adhesive coating solution was prepared from a latex polymer of MMA/BA/MAA/GMA (33/55/10/2), 0.1% Zonyl® FSA, and 6% butyl cellosolve in water, at 5% polymer solids. The solution was spin coated onto the glass, with a dried thickness of about 0.1 microns.

The color pattern on the receiver element was then laminated to the glass using a Tetrahedron press laminator (Tetrahedron, Inc. San Diego CA). A sandwich was made consisting of, from bottom to top, 1/16" stainless steel plate, Teflon® fluoropolymer sheet, fiber reinforced rubber sheet, glass substrate, receiver element with color pattern, such that the color pattern was adjacent the adhesive layer of the glass substrate, fiber reinforced rubber sheet, Teflon® sheet, and stainless steel plate. The sandwich was placed into the laminator, which was preheated to 175°F (85°C). The laminator then underwent a lamination cycle consisting of 3 bump cycles at 1000 pounds force, then a hold cycle at 10,000 pounds force for 3 minutes, then let down to zero force. The sandwich was removed from the laminator, and the glass/color filter assemblage was isolated from the sandwich. While the assemblage was still hot, the Cronar® support from the receiver element was peeled off. The Elvax® cushion layer was removed with the support, taking with it the Elvax® layer. The image-receiving layer and color filter pattern remained on the glass substrate to form the color filter element.

### Planarization Layer

A planarization was first formed separately by coating an aqueous latex dispersion of MMA/BA/MAA/GMA/Styrene (5:80:3:2:10) onto a support sheet of Melinex® 573 polyester, to a dried thickness of about 5 microns. This was then laminated to the color filter element, using the Tetrahedron press laminator. A sandwich was constructed consisting of, from bottom to top, 1/16" stainless steel plate, Teflon® sheet, fiber reinforced rubber sheet, color filter element from Example 2, planarizing film, such that the latex coating was adjacent the color filter pattern on the glass substrate, fiber reinforced rubber sheet, Teflon® sheet, and stainless steel plate. The sandwich was placed into the laminator, which was preheated to 265°F (135°C). The laminator then underwent a lamination cycle consisting of 3 bump cycles at 1000 pounds force, then a hold cycle at 10,000 pounds force for 3 minutes, then let down to zero force. The sandwich was removed from the laminator, and the glass /color filter/planarizer assemblage was isolated from the sandwich. The assemblage was allowed to cool to room temperature. The polyester backing was then peeled off, producing a planarized color filter. The filter was then baked in an oven at 150°C for ½ hour to crosslink the latex.

### First Electrical Contact Layer -- Anode

After the planarization step, the planarized color filter was cleaned with isopropanol, rinsed with water and dried under neutralized nitrogen gas stream.
A layer of indium tin oxide (ITO) was then vapor deposited to a thickness of 1850 Å.

### Hole Injection Layer

The ITO surface from above was cleaned by rinsing with isopropanol and deionized water and then treated for 2 minutes with an O₂ plasma cleaner.

For the hole injection layer, Baytron® P, a solution of poly(3,4-ethylenedioxythiophene) ("PEDOT") in water, with a total solid content of 1.3% by weight, available from Bayer (Leverkusen, Germany) was used. Baytron® P was mixed with a diluted solution of polystrene sulfonic acid ("PSSA") to yield a solution of 2% solids. 87 grams of the solution was prepared by mixing 60 grams Baytron® P, 3.2 grams PSSA (30% water) and 23.8 grams water.

The hole injection material was applied over the layer of indium tin oxide by spin coating at 2000 RPM in a nitrogen atmosphere. The dried coating had an approximate thickness of 500 Å.

### Light-Emitting Layer

A 0.65 wt % solution of a super-yellow emitter (PDY 131), which is a poly(substituted-phenylene vinylene) from Covion Company (Frankfurt, Germany), was made in toluene. Under a nitrogen atmosphere, this solution was spin coated over the hole injection layer. The dried coating had an approximate thickness of 1000 Å.

### Second Electrical Contact Layer -- Cathode

For the cathode, a layer of Yb was vapor deposited on top of the light-emitting layer under a vacuum of 1 x 10⁻⁶ torr. The final thickness of the Yb layer was about 1500 Å.

The devices were tested in a nitrogen atmosphere. The turn-on voltage was about 3 V. The light was quite bright and the colors could be readily seen and distinguished. The CIE coordinates are given in Table 2 below.

**Table 2**

| Color | CIE coordinate | |
|---|---|---|
| | x | y |
| red | 0.5603 | 0.4295 |
| green | 0.2670 | 0.6816 |
| blue | 0.1274 | 0.6801 |

## Claims

1. A process for forming a multicolor display comprising:
selectively exposing to heat an assemblage comprising a donor element comprising a transfer layer on a base support, wherein the transfer layer comprises at least one binder and a first colorant, and a receiver element comprising a support and an image receiving layer, thereby transferring portions of the transfer layer to form a desired patterned layer on the image receiving layer of the receiver element,
applying a transparent first electrical contact layer;
applying a layer of organic light-emitting material; and
applying a second electrical contact layer.

2. The process of claim 1 wherein the process further comprises applying a planarization layer to the patterned layer on the image receiving layer.

3. The process of Claim 1 wherein the transparent first electrical layer is applied to the patterned layer on the image receiving layer, the organic light-emitting material is applied to the first electrical contact layer and the second electrical contact layer is applied to the first electrical contact layer.

4. The process of Claim 2 wherein the planarization layer is applied to the patterned layer on the image receiving layer, the transparent first electrical layer is applied to the planarization layer, the organic light-emitting material is applied to the first electrical contact layer and the second electrical contact layer is applied to the first electrical contact layer.

5. The process of Claim 1 wherein the receiver support is a dimensionally stable transparent material.

6. The process of Claim 5 wherein the receiver support is glass,

7. The process of Claim 1, Claim 2, Claim 3 or Claim 4 further comprising transferring the patterned layer from the receiver element to a permanent substrate resulting in a the patterned layer being sandwiched between the image receiving layer and the permanent substrate.

8. The process of Claim 7 wherein the receiver support is removed.

9. The process of Claim 7 wherein the permanent substrate is a dimensionally stable transparent material.

10. The process of Claim 9 wherein the dimensionally stable transparent material is glass.

11. The process of Claim 1, Claim 2, Claim 3 or Claim 4 wherein the binder is a crosslinkable polymer.

12. The process of Claim 1, Claim 2, Claim 3 or Claim 4 wherein the binder comprises a first binder and a second binder, wherein the first binder has a Tg of at least 10 °C higher than the Tg of the second binder.

13. The process of Claim 1, Claim 2, Claim 3 or Claim 4 wherein the donor element further comprises a heating layer.

14. The process of Claim 1, Claim 2, Claim 3 or Claim 4 wherein the transfer layer further comprises a thermal amplification additive.

15. The process of Claim 1, Claim 2, Claim 3 or Claim 4 wherein the colorant is a pigment dispersion.

16. The process of Claim 1, Claim 2, Claim 3 or Claim 4 wherein the binder is selected from the group consisting of acrylate homopolymers, acrylate copolymers, methacrylate homopolymers, methacrylate copolymers, methacrylate block copolymers, and copolymers thereof with other monomers.

17. The process of Claim 16 wherein the other monomer is styrene.

18. The process of Claim 2 or claim 4 wherein the planarizing layer is selected from the group consisting of copolymers of methyl methacrylate, butyl methacrylate, methacrylic acid, and glycidyl methacrylate.

19. The process of Claim 1, Claim 2, Claim 3 or Claim 4 wherein the first electrical contact layer is an anode selected from the group consisting of aluminum, silver, platinum, gold, palladium, tungsten, indium, tin, copper, iron, nickel, zinc, lead; alloys thereof; doped inorganic semiconductors; metal oxides of Groups 2, 3 and 4, and mixed metal oxides of Groups 2, 3 and 4.

20. The process of Claim 1, Claim 2, Claim 3 or Claim 4 wherein the light-emitting material is an organic electroluminescent material.

21. The process of Claim 20 wherein the light-emitting material is selected from the group consisting of anthracene, naphthalene, phenanthrene, pyrene, chysene, perylene, butadienes, coumarin derivatives, acridine, stilbenes, metal chelated oxinoid compounds, and semiconductive conjugated polymers.

22. The process of Claim 1, Claim 2, Claim 3 or Claim 4 wherein the second electrical contact layer is a cathode selected from the group consisting of alkali metals of Group 1, the Group 2 (alkaline earth) metals, the lanthanides and the actinides.

23. The process of Claim 1, Claim 2, Claim 3 or Claim 4 further comprising a charge transport layer between the first electrical contact layer and the layer of organic light-emitting material.

24. The process of Claim 23 wherein the charge transport layer comprises hole transporting molecules selected from the group consisting of N,N'-diphenyl-N,N'-bis(3-methylphenyl)-[1,1'-biphenyl]-4,4'-diamine, 1,1-bis[(di-4-tolylamino) phenyl]cyclohexane, N,N'-bis(4-methylphenyl)-N,N'-bis(4-ethylphenyl)-[1,1'-(3,3'-dimethyl)biphenyl]-4,4'-diamine, Tetrakis-(3-methylphenyl)-N,N,N',N'-2,5-phenylenediamine, a-Phenyl-4-N,N-diphenylaminostyrene, p-(Diethylamino)-benzaldehyde diphenylhydrazone, Triphenylamine, Bis[4-(N,N-diethylamino)-2-methylphenyl](4-methylphenyl)methane, 1-Phenyl-3-[p-(diethylamino)styryl]-5-[p-(diethylamino)phenyl] pyrazoline, 1,2-Trans-bis(9H-carbazol-9-yl)cyclobutane (DCZB), N,N,N',N'-tetrakis(4-methylphenyl)-(1,1'-biphenyl)-4,4'-diamine, and porphyrinic compounds.

25. The process of Claim 23 wherein the charge transport layer comprises a conducting organic polymer.

26. The process of Claim 25 wherein the conducting organic polymer is polyaniline or polythiophene blended with polystyrene sulfonic acid.

27. The process of Claim 1, Claim 2, Claim 3 or Claim 4 further comprising an electron transport layer between the organic light-emitting material and the cathode.

28. The process of Claim 27 wherein the electron transport layer is selected from the group consisting of metal chelated oxinoid compounds; phenanthroline-based compounds and azole compounds.

29. A process for forming a multicolor display comprising, in order:
selectively exposing to heat an assemblage comprising a donor element comprising a transfer layer on a base support, wherein the transfer layer comprises at least one binder and a first colorant, and a receiver element comprising a support and an image receiving layer, thereby transferring portions of the transfer layer to form a desired patterned layer on the image receiving layer of the receiver element,
applying a transparent first electrical contact layer;
applying a layer of organic light-emitting material; and
applying a second electrical contact layer.

30. A process for forming a multicolor display comprising, in order:
selectively exposing to heat an assemblage comprising a donor element comprising a transfer layer on a base support, wherein the transfer layer comprises at least one binder and a first colorant, and a receiver element comprising a support and an image receiving layer, thereby transferring portions of the transfer layer to form a desired patterned layer on the image receiving layer of the receiver element,
applying a planarization layer;
applying a transparent first electrical contact layer;
applying a layer of organic light-emitting material; and
applying a second electrical contact layer.
